(19) Europäisches Patentamt / European Patent Office / Office européen des brevets

(11) **EP 4 269 023 A1**

(12) **EUROPEAN PATENT APPLICATION**
published in accordance with Art. 153(4) EPC

(43) Date of publication:
**01.11.2023 Bulletin 2023/44**

(21) Application number: **21910253.0**

(22) Date of filing: **06.12.2021**

(51) International Patent Classification (IPC):
**B24B 37/00** (2012.01)      **H01L 21/304** (2006.01)

(52) Cooperative Patent Classification (CPC):
**B24B 37/00; H01L 21/304**

(86) International application number:
**PCT/JP2021/044672**

(87) International publication number:
**WO 2022/138103 (30.06.2022 Gazette 2022/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.12.2020 JP 2020212274**

(71) Applicant: **Fujimi Incorporated
Kiyosu-shi, Aichi 452-8502 (JP)**

(72) Inventor: **TANABE, Yoshiyuki
Kiyosu-shi, Aichi 452-8502 (JP)**

(74) Representative: **Grünecker Patent- und
Rechtsanwälte
PartG mbB
Leopoldstraße 4
80802 München (DE)**

(54) **POLISHING COMPOSITION**

(57)    The present invention provides means for achieving high polishing removal rate in polishing a silicon wafer.

The present invention relates to a polishing composition used for polishing a silicon wafer, comprising a nitrogen-containing organic compound having an energy level of the highest occupied molecular orbital (HOMO) of -9.50 eV or more, and water.

EP 4 269 023 A1

**Description**

**TECHNICAL FIELD**

The present invention relates to a polishing composition.

**BACKGROUND ART**

Metals such as silicon, aluminum, nickel, tungsten, copper, tantalum, titanium and stainless steel or semiconductors, or alloys thereof; and compound semiconductor wafer materials such as silicon carbide, gallium nitride, gallium arsenide, and the like are subjected to polishing according to various requirements such as flattening and are applied in various fields.

Mirror wafers having a high-quality mirror surface which is highly flat and free from scratches and impurities are used as semiconductor elements such as integrated circuits, and various studies have been carried out on techniques for polishing single-crystalline silicon substrates (silicon wafers) in order to produce such mirror wafers.

For example, International Publication No. WO2015/102101 proposes a polishing composition containing colloidal silica, a salt of a weak acid, and a quaternary ammonium compound, in which the contents of the salt of a weak acid and the quaternary ammonium compound fall within specific ranges.

**SUMMARY OF INVENTION**

Technical Problem

However, further improvement of polishing removal rate is required in the technique described in International Publication No. WO2015/102101.

Accordingly, the present invention aims at providing means capable of realizing high polishing removal rate in polishing a silicon wafer.

The problem described above is solved by a polishing composition used for polishing a silicon wafer, containing a nitrogen-containing organic compound having an energy level of the highest occupied molecular orbital (HOMO) of -9.50 eV or more, and water.

**DESCRIPTION OF EMBODIMENTS**

Hereinafter, embodiments of the present invention will be described. However, the present invention is not limited only to the following embodiments. In addition, operation and measurement on physical properties and the like are measured under the conditions of room temperature (range of 20°C or more and 25°C or less)/relative humidity of 40% RH or more and 50% RH or less unless otherwise stated.

Hereinafter, details of a polishing composition of the present invention will be described.

[Polishing Composition]

One embodiment of the present invention is a polishing composition used for polishing a silicon wafer, containing a nitrogen-containing organic compound having an energy level of the highest occupied molecular orbital (HOMO) (hereinafter, also simply referred to as the "HOMO level") of -9.50 eV or more, and water. According to such a polishing composition of the present invention, silicon wafers can be polished at high polishing removal rate.

Although the working mechanism by which the above-described effect is obtained with the polishing composition of the present invention is not clear, it is considered as follows. The HOMO level of the nitrogen-containing organic compound according to the present invention is -9.50 eV or more, and unshared electron pairs of nitrogen atoms have high nucleophilicity. The silicon-silicon bond in a silicon wafer is weakened due to nucleophilic attack by these unshared electron pairs on a silicon wafer surface. Consequently, a film surface (that is, a polishing surface) of the silicon wafer is embrittled, and silicon wafer polishing removal rate is considered to improve.

The mechanism described above is based on speculation, and whether it is correct or not does not affect the technical scope of the present application.

[Object to be polished]

The polishing composition according to the present invention is used for application for polishing a silicon wafer. Herein, the silicon wafer may be one made from elemental silicon such as a single-crystalline silicon substrate and a polycrystalline silicon substrate or may be one composed of a layer formed from elemental silicon and another layer. In addition, it is acceptable that the silicon wafer contains an element other than silicon in a content to the extent of impurities. Therefore, the silicon wafer may contain a p-type dopant such as boron and an n-type dopant such as phosphorus. A crystal orientation of the silicon wafer is also not particularly limited and may be any of <100>, <110>, and <111>. In addition, a resistivity of the silicon wafer is also not particularly limited. A thickness of the silicon wafer is 600 to 1000 $\mu$m, for example, but is not particularly limited. A diameter of the silicon wafer is also not limited, and the present composition is applicable to wafers with any diameter.

Next, constituent components of the polishing composition of the present invention will be described.

[Nitrogen-containing organic compound]

The polishing composition of the present invention contains a nitrogen-containing organic compound with the HOMO level of -9.50 eV or more. A silicon wafer surface is subjected to nucleophilic attack by the nitrogen-containing organic compound, and silicon-silicon bond in the silicon wafer is weakened. Consequently, a film surface (that is, a polishing surface) of the silicon wafer is embrittled, and silicon wafer polishing removal rate is considered to improve.

The HOMO level herein was calculated using parametric method 7 (PM7 method), which is a Hamiltonian function of semi-empirical molecular orbital program MOPAC.

When the HOMO level of the nitrogen-containing organic compound is less than -9.50 eV, silicon wafer polishing removal rate decreases. The HOMO level is preferably -9.30 eV or more and more preferably -9.20 eV or more. The upper limit of the HOMO level is not particularly limited but is usually 0 eV or less.

The number of nitrogen atoms contained in the nitrogen-containing organic compound should be one or more and is not particularly limited. A compound containing 1 or more and 10 or less nitrogen atoms within its molecule can be preferably used as the nitrogen-containing organic compound in the technology disclosed herein. The lower limit of the number of nitrogen atoms contained in the nitrogen-containing organic compound may be 1 or more, 2 or more, 3 or more, and 4 or more. The upper limit of the number of nitrogen atoms contained in the nitrogen-containing organic compound may be 10 or less, 8 or less, 6 or less, 5 or less, and 4 or less.

A nitrogen atom contained in the nitrogen-containing organic compound herein may be within a saturated hetero ring, or may be present outside a saturated hetero ring. The lower limit of the number of nitrogen atoms contained in a saturated hetero ring may be 1 or more, 2 or more, 3 or more, and 4 or more. The upper limit of the number of nitrogen atoms contained in a saturated hetero ring may be 5 or less, 4 or less, 3 or less, and 2 or less. The lower limit of the number of nitrogen atoms contained outside a saturated hetero ring may be 1 or more, 2 or more, 3 or more, and 4 or more. The upper limit of the number of nitrogen atoms contained outside a saturated hetero ring may be 5 or less, 4 or less, 3 or less, and 2 or less.

Examples of the nitrogen-containing organic compound used in the present invention are shown below. Numerical values in parentheses are HOMO level values.

Examples include diethylamine (-8.91 eV), ethylenediamine (-9.45 eV), 1-(3-aminopropyl)imidazole (-9.42 eV), piperazine (-8.96 eV), N-(2-aminoethyl)piperazine (-8.90 eV), 1,4-bis(3-aminopropyl)piperazine (-8.59 eV), 4-aminopiperidine (-9.17 eV), cis-1,2-cyclohexanediamine (-9.13 eV), 1,4-diazabicyclo[2,2,2]octane (DABCO) (-8.65 eV), triethylenetetramine (-8.87 eV), 1,8-diazabicyclo[5,4,0]undec-7-ene (DBU) (-8.55 eV), 1,5-diazabicyclo[4,3,0]non-5-ene (DBN) (-8.70 eV), quinuclidine(1-azabicyclo[2,2,2]octane) (-8.91 eV), homoquinuclidine (1-azabicyclo[3,2,2]nonane) (-8.57 eV), and granatane(9-methyl-9-azabicyclo[3,3,1]nonane) (-8.50 eV) .

The nitrogen-containing organic compound can be used singly or in combination of two or more kinds. In addition, for the nitrogen-containing organic compound, commercially available products may be used, or synthetic products may be used.

Among these nitrogen-containing organic compounds, a compound having a saturated hydrocarbon cyclic group or a saturated heterocyclic group containing one nitrogen atom is preferable. It is considered that since such a compound has no unsaturated bond, resulting in electron localization of the lone electron pair on a nitrogen atom, nucleophilic attack on a silicon wafer surface more efficiently occurs. Therefore, silicon wafer polishing removal rate is considered to be further increased.

The compound having a saturated hydrocarbon cyclic group or a saturated heterocyclic group containing one nitrogen atom may be a monocyclic compound or a polycyclic compound. The form of linkage between rings in a polycyclic compound is not particularly limited and includes ring assembly, crosslinking, condensation, spiro-condensation, and the like.

Examples of the saturated hydrocarbon ring include a cyclopropane ring, a cyclobutene ring, a cyclopentane ring, a cyclohexane ring, a cycloheptane ring, a cyclooctane ring, a norbornane ring, a bornane ring, an adamantane ring, a tetrahydronaphthalene ring, and a bicyclo[2.2.2]octane ring.

Examples of the saturated hetero ring including one nitrogen atom include an azetidine ring, a pyrrolidine ring, morpholine ring, a thiomorpholine ring, a piperidine ring, a hexahydroazepin ring, an azabicyclo[3.2.1]octane ring, a 1,4-hexahydro oxazepine ring, an octahydro azocine ring, an octahydro indole ring, a 3-azabicyclo[3.1.0]hexane ring, a 1-azabicyclo[2,2,2]octane ring, a 1-azabicyclo[3,2,2]nonane ring, and a 9-azabicyclo[3,3,1]nonane ring.

More specific examples of the nitrogen-containing organic compound having a saturated hydrocarbon cyclic group or a saturated heterocyclic group containing one nitrogen atom include 4-aminopiperidine (-9.17 eV), cis-1,2-cyclohexanediamine (-9.13 eV), quinuclidine(1-azabicyclo[2,2,2]octane) (-8.91 eV), homoquinuclidine (1-azabicyclo[3,2,2]nonane) (-8.57 eV), and granatane(9-methyl-9-azabicyclo[3,3,1]nonane) (-8.50 eV).

When the polishing composition is directly used as a polishing liquid, a lower limit of a content (concentration) of the nitrogen-containing organic compound is preferably 0.20 mM (M means mol/L) or more, more preferably 0.50 mM or more, and still more preferably 1.00 mM or more, based on the total amount of the polishing composition. In addition, when the polishing composition is directly used as a polishing liquid, an upper limit of the content (concentration) of the nitrogen-containing organic compound is preferably 10.0 mM or less, more preferably 5.0 mM or less, and still more preferably 3.0 mM or less, based on the total amount of the polishing composition. A silicon wafer can be polished at high polishing removal rate within such a content range.

In addition, when the polishing composition is diluted and used for polishing, that is, when the polishing composition is a concentrate, from the viewpoint of storage stability, etc., the upper limit of the content of the nitrogen-containing organic compound is preferably 100 mM or less and more preferably 50 mM or less, based on the total amount of the polishing composition. In addition, from the viewpoint of taking advantage of making the polishing composition into a concentrate, the lower limit of the content of the nitrogen-containing organic compound is preferably 10 mM or more and more preferably 20 mM or more, based on the total amount of the polishing composition.

When two or more kinds of the nitrogen-containing organic compound are used in combination, the above-described content refers to a total content of two or more kinds of the nitrogen-containing organic compound.

The content of the nitrogen-containing organic compound may be also specified by relative relationship with an abrasive contained in the polishing composition. Specifically, the content of the nitrogen-containing organic compound in the polishing composition is suitable to be about 0.01 parts by mass or more and, from the viewpoint of improving polishing removal rate, is preferably about 0.1 parts by mass or more and more preferably about 0.5 parts by mass or more (for example, about 0.6 parts by mass or more), based on 100 parts by mass of the abrasive. In addition, from the viewpoint of improving polishing surface quality, the content of the nitrogen-containing organic compound is suitable to be about 10 parts by mass or less and is preferably about 5 parts by mass or less and more preferably about 3 parts by mass or less (for example, about 2.5 parts by mass or less), based on 100 parts by mass of the abrasive.

In addition, the content of the nitrogen-containing organic compound may be also specified by relative relationship with a content of a basic compound contained in the polishing composition. Specifically, a ratio ($C_N/C_B$) of the content ($C_N$) of the nitrogen-containing organic compound to the content ($C_B$) of the basic compound is suitable to be 0.001 or more and, from the viewpoint of improving polishing removal rate, is preferably 0.01 or more and more preferably 0.05 or more (for example, 0.1 or more). In addition, from the viewpoint of improving polishing surface quality, the ratio ($C_N/C_B$) is suitable to be 1000 or less, is preferably 200 or less and more preferably 100 or less, and may be 20 or less (for example, 10 or less).

[Water]

The polishing composition according to the present invention contains water as a dispersion medium in order to disperse or dissolve each component. It is preferable that water contain as little impurities as possible from the viewpoint of preventing contamination of a silicon wafer and preventing the actions of other components from being inhibited. Such water is preferably water in which a total content of transition metal ions is 100 ppb or less, for example. Herein, the purity of water can be enhanced by an operation such as removal of ion impurities using ion-exchange resin, removal of contaminants by a filter, and distillation, for example. Specifically, it is preferable that deionized water (ion-exchanged water), pure water, ultrapure water, distilled water, or the like be used as water, for example.

Water and an organic solvent may be used in combination in order to disperse or dissolve each component, and the organic solvent can be used singly or in combination of two or more kinds. In this case, the organic solvent used includes acetone, acetonitrile, ethanol, methanol, isopropanol, glycerin, ethylene glycol, propylene glycol, etc., which are organic solvents miscible with water. In addition, these organic solvents may be used without being mixed with water and then mixed with water after dispersing or dissolving each component.

[Abrasive]

The polishing composition of the present invention preferably contains an abrasive. The abrasive contained in the polishing composition have a function to mechanically polish silicon wafers.

The abrasive used in the present invention can be used singly or in combination of two or more kinds. The abrasive may be any of inorganic particles, organic particles, and organic-inorganic composite particles. Specific examples of the inorganic particles include, for example, particles formed from a metal oxide such as silica, alumina, ceria, and titania, silicon nitride particles, silicon carbide particles, and boron nitride particles. Specific examples of the organic particles include, for example, polymethyl methacrylate (PMMA) particles. In addition, for the abrasive, commercially available products may be used, or synthetic products may be used. Unless otherwise specified herein, the abrasive refer to those without surface modification.

Among these abrasives, silica is preferable, and colloidal silica is especially preferable.

A lower limit of an average primary particle size of the abrasive is preferably 10 nm or more, more preferably 15 nm or more, still more preferably 20 nm or more, further preferably 30 nm or more, even more preferably 40 nm or more, and especially preferably 50 nm or more. In such a range, high polishing removal rate can be maintained, and the abrasive is thus suitably used in a rough polishing step. In addition, an upper limit of the average primary particle size of the abrasive is preferably 200 nm or less, more preferably 150 nm or less, and still more preferably 100 nm or less. In several aspects, the average primary particle size may be 75 nm or less, or may be 60 nm or less. In such a range, occurrence of defects on the surface of a silicon wafer after polishing can be further suppressed. The average primary particle size of the abrasive is calculated on the basis of a specific surface area of the abrasive measured by a BET method, for example.

A lower limit of an average secondary particle size of the abrasive is preferably 15 nm or more, more preferably 30 nm or more, still more preferably 40 nm or more, even more preferably 50 nm or more, and especially preferably 60 nm or more (for example, 80 nm or more). In such a range, high polishing removal rate can be maintained. In addition, an upper limit of the average secondary particle size of the abrasive is preferably 300 nm or less, more preferably 260 nm or less, still more preferably 220 nm or less, and especially preferably 150 nm or less (for example, 130 nm or less). In such a range, occurrence of defects on the surface of a silicon wafer after polishing can be further suppressed. The average secondary particle size of the abrasive can be measured by a dynamic light scattering method. For example, the average secondary particle size of the abrasive can be measured using "FPAR-1000" model manufactured by Otsuka Electronics Co., Ltd. or an equivalent thereof.

An average association degree of the abrasive is preferably 1.2 or more, more preferably 1.4 or more, and still more preferably 1.5 or more. The average association degree herein is obtained by dividing the value of the average secondary particle size of the abrasive by the average primary particle size. When the average association degree of the abrasive is 1.2 or more, an advantageous effect of improving polishing removal rate is provided, which is preferable. In addition, the average association degree of the abrasive is preferably 4 or less, more preferably 3.5 or less, and still more preferably 3 or less. As the average association degree of the abrasive becomes smaller, a polishing surface with less surface defects, which are caused by polishing the object to be polished using the polishing composition, is easily obtained.

When the polishing composition is directly used as a polishing liquid, a content of the abrasive is preferably 0.1% by mass or more, more preferably 0.4% by mass or more, and still more preferably 1.0% by mass or more, based on the polishing composition. Polishing removal rate is improved by increase of the content of the abrasive. In addition, when the polishing composition is directly used as a polishing liquid, from the viewpoint of preventing scratches, etc., the content of the abrasive is usually suitable to be 10% by mass or less and is preferably 5% by mass or less, more preferably 3% by mass or less, and still more preferably 2% by mass or less. Reducing the content of the abrasive is also preferable from the viewpoint of economic efficiency.

In addition, when the polishing composition is diluted and used for polishing, that is, when the polishing composition is a concentrate, from the viewpoint of storage stability, filterability, etc., the content of the abrasive is preferably 50% by mass or less and more preferably 40% by mass or less, based on the polishing composition in usual. In addition, from the viewpoint of taking advantage of making the polishing composition into a concentrate, the content of the abrasive is preferably 1% by mass or more and more preferably 5% by mass or more.

When two or more kinds of the abrasive are used in combination, the above-described content refers to a total content of two or more kinds of the abrasive.

[Basic compound]

The polishing composition according to the present invention preferably contains a basic compound. The basic compound herein refers to a compound functioning to increase the pH of the composition by being added to the polishing composition, and is other than the nitrogen-containing organic compound with the HOMO level of -9.50 eV or more. The basic compound functions to chemically polish the surface to be polished and can contribute to improvement in polishing removal rate. In addition, the basic compound can help in improving dispersion stability of the polishing composition.

The basic compound used in the present invention can be used singly or in combination of two or more kinds. The basic compound includes an organic or inorganic basic compound including nitrogen, a hydroxide of an alkali metal or Group 2 metal, and various carbonates and hydrogen carbonates; a quaternary ammonium hydroxide or a salt thereof; and ammonia, amine, etc. Specific examples of the hydroxide of an alkali metal include potassium hydroxide, sodium hydroxide, etc. Specific examples of the carbonates or hydrogen carbonates include ammonium hydrogen carbonate, ammonium carbonate, potassium hydrogen carbonate, potassium carbonate, sodium hydrogen carbonate, sodium carbonate, etc. Specific examples of the quaternary ammonium hydroxide or salt thereof include tetramethylammonium hydroxide (TMAH), tetraethylammonium hydroxide, tetrabutylammonium hydroxide, etc. Specific examples of the amine include hexamethylenetetramine; azoles such as an imidazol and a triazol; pyridine; etc.

From the viewpoint of improving polishing removal rate, etc., a preferable basic compound includes at least one kind selected from the group consisting of ammonia, potassium hydroxide, sodium hydroxide, tetramethylammonium hydroxide, tetraethylammonium hydroxide, ammonium hydrogen carbonate, ammonium carbonate, potassium hydrogen carbonate, potassium carbonate, sodium hydrogen carbonate, and sodium carbonate. Among others, as a more preferable basic compound, at least one selected from the group consisting of ammonia, potassium hydroxide, sodium hydroxide, tetramethylammonium hydroxide, tetraethylammonium hydroxide, and potassium carbonate is exemplified.

When the polishing composition is directly used as a polishing liquid, a lower limit of a content (concentration) of the basic compound in the polishing composition is preferably 3 mM or more and more preferably 5 mM or more. In such a range, high polishing removal rate can be maintained. In addition, stability can also be improved by increasing the concentration of the basic compound. In addition, when the polishing composition is directly used as a polishing liquid, an upper limit of the content (concentration) of the basic compound is preferably 50 mM or less, more preferably 30 mM or less, and still more preferably 10 mM or less.

In addition, when the polishing composition is diluted and used for polishing, that is, when the polishing composition is a concentrate, from the viewpoint of storage stability, filterability, etc., the upper limit of the content (concentration) of the basic compound is preferably 400 mM or less, more preferably 350 mM or less, and still more preferably 300 mM or less. In addition, from the viewpoint of taking advantage of making the polishing composition into a concentrate, the lower limit of the content (concentration) of the basic compound is preferably 50 mM or more, more preferably 100 mM or more, and still more preferably 150 mM or more.

When two or more kinds of the basic compound are used in combination, the above-described content refers to a total content of two or more kinds of the basic compound.

[Other components]

The polishing composition according to the present invention may optionally further contain known additives which can be used for polishing compositions such as a water-soluble polymer, a surfactant, a chelating agent, an antiseptic agent, and an antifungal agent within a range not significantly impairing the effect of the present invention.

Examples of the water-soluble polymer include a cellulose derivative, a starch derivative, a polymer containing an oxyalkylene unit, a polymer containing a nitrogen atom, a vinyl alcohol-based polymer, etc. Specific examples thereof include hydroxyethyl cellulose, pullulan, a random copolymer or block copolymer of ethylene oxide and propylene oxide, polyvinyl alcohol, acetalized polyvinyl alcohol, copolymer of vinyl alcohol and an alkylene oxide, polyisoprene sulfonic acid, polyvinyl sulfonic acid, polyallyl sulfonic acid, polyisoamylene sulfonic acid, polystyrene sulfonate, polyacrylate, polyvinyl acetate, polyethylene glycol, polyvinylimidazole, polyvinylcarbozole, polyvinylpyrrolidone, polyvinyl caprolactam, polyvinyl piperidine, polyacryloylmorpholine, polyhydroxyacrylamide, etc. The water-soluble polymer can be used singly or in combination of two or more kinds. The polishing composition disclosed herein can be preferably carried out also in an aspect containing substantially no water-soluble polymer, that is, in an aspect to which a water-soluble polymer is not at least intentionally contained.

(Surfactant)

The polishing composition of the present invention may optionally further contain a surfactant such as a nonionic surfactant, a cationic surfactant, and an anionic surfactant.

The nonionic surfactant available for the present invention can be used singly or in combination of two or more kinds. Examples of the nonionic surfactant include alkyl betaine, alkyl amine oxide, polyoxyethylene alkyl ether, polyoxyalkylene alkyl ether, sorbitan fatty acid ester, glycerin fatty acid ester, polyoxyethylene fatty acid ester, polyoxyethylene alkyl amine, alkyl alkanol amide, etc. Among them, from the viewpoint of improving dispersion stability of the polishing composition, a polyoxyalkylene alkyl ether is preferable, and a polyoxyethylene alkyl ether is more preferable.

When the polishing composition is directly used as a polishing liquid, a content of the nonionic surfactant is preferably 0.00001% by mass or more, more preferably 0.00002% by mass or more, and still more preferably 0.00003% by mass or more, based on the polishing composition. In such a range, dispersion stability of the polishing composition is improved. When the polishing composition is directly used as a polishing liquid, it is appropriate to set an upper limit of the content of the nonionic surfactant to 0.002% by mass or less, and the upper limit is preferably 0.001% by mass or less, from the viewpoint of maintaining high polishing removal rate.

In addition, when the polishing composition is diluted and used for polishing, that is, when the polishing composition is a concentrate, from the viewpoint of storage stability, filterability, etc., the content of the nonionic surfactant is usually suitable to be 0.1% by mass or less and is more preferably 0.05% by mass or less. In addition, from the viewpoint of taking advantage of making the polishing composition into a concentrate, the content of the nonionic surfactant is preferably 0.0001% by mass or more, more preferably 0.0002% by mass or more, and still more preferably 0.0005% by mass or more.

When two or more kinds of the nonionic surfactant are used in combination, the above-described content refers to a total content of two or more kinds of the nonionic surfactant.

(Chelating agent)

The chelating agent which may be contained in the polishing composition can be used singly or in combination of two or more kinds. The chelating agent includes an aminocarboxylic acid-based chelating agent and an organic phosphonic acid-based chelating agent. Examples of the aminocarboxylic acid-based chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, diethylenetriaminepentaacetic acid, sodium diethylenetriaminepentaacetic acid, triethylenetetraminehexaacetic acid, and sodium triethylenetetraminehexaacetic acid. Examples of the organic phosphonic acid-based chelating agent includes 2-aminoethylphosphonic acid, 1-hydroxyethylidene-1,1-diphosphonic acid, aminotri(methylenephosphonic acid), ethylenediaminetetrakis(methylenephosphonic acid) (EDTPO), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and $\alpha$-methylphosphonosuccinic acid. Among them, organic phosphonic acid-based chelating agents are more preferable. Among others, preferable chelating agents include ethylenediaminetetrakis(methylenephosphonic acid), diethylenetriaminepenta(methylenephosphonic acid), and diethylenetriaminepentaacetic acid. Especially preferable chelating agents include ethylenediaminetetrakis(methylenephosphonic acid) and diethylenetriaminepenta(methylenephosphonic acid).

When the polishing composition is directly used as a polishing liquid, a lower limit of a content of the chelating agent is preferably 0.0001% by mass or more, more preferably 0.001% by mass or more, and still more preferably 0.002% by mass or more, based on the polishing composition. An upper limit of the content of the chelating agent is preferably 1% by mass or less, more preferably 0.5% by mass or less, still more preferably 0.3% by mass or less, and especially preferably 0.15% by mass or less.

In addition, when the polishing composition is diluted and used for polishing, that is, when the polishing composition is a concentrate, from the viewpoint of storage stability, filterability, etc., the content of the chelating agent is usually suitable to be 5% by mass or less and is more preferably 3% by mass or less and especially preferably 1.5% by mass or less. In addition, from the viewpoint of taking advantage of making the polishing composition into a concentrate, the content of the chelating agent is preferably 0.001% by mass or more, more preferably 0.01% by mass or more, and still more preferably 0.05% by mass or more.

When two or more kinds of the chelating agent are used in combination, the content described above refers to a total content of two or more kinds of the chelating agent.

The antiseptic agent and antifungal agent which may be contained in the polishing composition can be used singly or in combination of two or more kinds. The antiseptic agent and antifungal agent include an isothiazolin-based antiseptic agent such as 2-methyl-4-isothiazolin-3-one and 5-chloro-2-methyl-4-isothiazolin-3-one, p-hydroxybenzoate esters, phenoxyethanol, etc., for example.

It is preferable that the polishing composition disclosed herein contains substantially no oxidant. This is because when the polishing composition contains an oxidant, a surface of a silicon wafer is oxidized through supply of the composition to produce an oxide film, which may decrease a polishing removal rate. Herein, the polishing composition containing substantially no oxidant means that an oxidant is not at least intentionally blended, and unavoidable inclusion of a trace amount of an oxidant derived from raw material or due to production processes can be acceptable. The trace amount indicates that a molar concentration of the oxidant in the polishing composition is 0.0005 mol/L or less (preferably 0.0001 mol/L or less, more preferably 0.00001 mol/L or less, and especially preferably 0.000001 mol/L or less). A polishing composition according to one preferable aspect contains no oxidant. The polishing composition disclosed herein can be preferably carried out in an aspect containing none of hydrogen peroxide, sodium persulfate, ammonium persulfate, and sodium dichloroisocyanurate, for example.

[Properties of polishing composition]

The polishing composition according to the present invention is supplied to the silicon wafer described above typically in the form of a polishing liquid including the polishing composition, and used for roughly polishing the silicon wafer. The polishing composition according to the present invention may be diluted and used as a polishing liquid or may be directly used as a polishing liquid, for example. Dilution herein is typically dilution with water. The concept of the polishing composition in the technology according to the present invention encompasses both a polishing liquid (working slurry) to be supplied to a silicon wafer and used for polishing and a concentrate (undiluted solution of working slurry) to be diluted and used for polishing. A concentration factor of the concentrate described above can be about two times or more and 140 times or less on volume basis, for example, and is usually suitable to be about 4 times or more and 80 times or less (for example, about 5 times or more and 50 times or less).

When the polishing composition is directly used as a polishing liquid, a pH of the polishing composition is preferably 8.0 or more, more preferably 8.5 or more, still more preferably 9.5 or more, and especially preferably 10.0 or more (for example, 10.2 or more). Polishing removal rate increases as the pH of the polishing composition increases. On the other hand, when the polishing composition is directly used as a polishing liquid, the pH of the polishing composition is preferably 12.0 or less and more preferably 11.5 or less. When the pH of the polishing composition is 12.0 or less, dissolution of an abrasive can be suppressed and prevent the reduction of mechanical polishing action by the abrasive.

In addition, when the polishing composition is diluted and used for polishing, that is, when the polishing composition is a concentrate, the pH of the polishing composition is preferably 9.5 or more, more preferably 10.0 or more, and sill more preferably 10.5 or more. In addition, it is appropriate that the pH of the polishing composition is 12.0 or less, and the pH of the polishing composition is preferably 11.5 or less.

The pH of the polishing composition can be measured by using a pH meter. After tree-point calibration is performed on a pH meter using standard buffer solutions, a glass electrode is put in the polishing composition. Then, the pH of the polishing composition can be obtained by measuring the value after a lapse of two or more minutes and after the pH is stabilized. For example, a glass electrode-type hydrogen ion concentration indicator (model number: F-72) manufactured by HORIBA, Ltd. can be used as the pH meter. In addition, the standard buffer solutions are, for example, a phthalate pH buffer solution (pH: 4.01), a neutral phosphoric acid salt pH buffer solution (pH: 6.86), and a carbonic acid salt pH buffer solution (pH: 10.01). The pH values herein are values at 25°C.

The polishing composition according to the present invention may be a one-component type or may be a multiple-component type including a two-component type. The multiple-component type is a combination of liquids in which a part or the whole of the polishing composition is mixed at an arbitrary mixing ratio. In addition, when a polishing device having multiple supplying paths for the polishing composition is used, preliminarily adjusted two or more polishing compositions may be used so that the polishing compositions are mixed on the polishing device.

[Production method for polishing composition]

The polishing composition of the present invention can be obtained by stirring and mixing respective components in water, for example. However, the method is not limited thereto. In addition, a temperature at which respective components are mixed is not particularly limited but is preferably 10°C or higher and 40°C or lower, and heating may be carried out so as to increase rates of dissolution. In addition, mixing time is also not particularly limited.

[Polishing method]

The polishing composition according to the present invention may be used for a silicon wafer polishing step in an aspect including the following operations, for example. Accordingly, the present invention also provides a polishing method for polishing a silicon wafer using the above-described polishing composition.

First, the polishing composition according to the present invention is prepared. Thereafter, the polishing composition is supplied to a silicon wafer, and polishing is performed in a usual manner. For example, a silicon wafer is set in a general polishing device, and the polishing composition is supplied to a surface (surface to be subjected to polishing) of the silicon waver through a polishing pad of the polishing device. Typically, the polishing pad is pressed against the surface of the silicon wafer and the two are relatively moved (for example, rotationally moved), while continuously supplying the polishing composition described above. Polishing of the silicon wafer is completed through such a polishing step.

The polishing pad used for the above-described step is not particularly limited. For example, any of a polyurethane type, a non-woven fabric type, a suede type, one including an abrasive, one not including an abrasive, etc. may be used. In addition, as the polishing device described above, a double side polishing device that simultaneously polishes the both sides of a silicon wafer may be used, or a single side polishing device that polishes only single side of a silicon wafer may be used.

While polishing conditions are also not particularly limited, rotation speed of the platen is preferably 10 rpm or more and 500 rpm or less, for example, and pressure (polishing pressure) applied to the silicon wafer is 3 kPa or more and 70 kPa or less and is preferably 3.45 kPa or more and 69 kPa or less, for example. A method for supplying the polishing composition to the polishing pad is also not particularly limited, and a continuous supplying method using a pump or the like is adopted, for example. While a supplying amount thereof is not limited, it is preferable that the surface of the polishing pad be always covered with the polishing composition of the present invention.

The polishing composition described above may be used in a so-called "one-way" or may be recycled and repeatedly used. The term one-way herein refers to an aspect in which the polishing composition once used for polishing is thrown away. A method for recycling the polishing composition and using the same includes the following example: a method in which a used polishing composition discharged from a polishing device is collected in a tank, and the collected polishing composition is supplied to the polishing device again. When the polishing composition is recycled and used, an environmental burden can be reduced. This is because the amount of the used polishing composition to be disposed as waste liquid is decreased compared with the case where the polishing composition is used in a one-way. In addition, costs can be suppressed as the amount used of the polishing composition decreases.

[Application]

As described above, the polishing composition of the present invention can polish a silicon wafer at high polishing removal rate. Utilizing said features, the polishing composition disclosed herein can be preferably used, in particular, in a stock polishing step, that is, a first polishing step (primary polishing step) or a subsequent intermediate polishing step (secondary polishing step) in the polishing step. The above-described stock polishing step is typically carried out as a double side polishing step in which both sides of a silicon wafer are simultaneously polished. The polishing composition disclosed herein can be preferably used in such a double side polishing step.

**Examples**

The present invention will be described in more detail with reference to the following Examples and Comparative Example. However, the technical scope of the present invention is not limited only to the following Examples.

The energy level of the HOMO of each nitrogen-containing organic compound was calculated using parametric method 7 (PM7 method), which is a Hamiltonian function of semi-empirical molecular orbital program MOPAC.

The pH of each polishing composition was measured using a pH glass electrode-type hydrogen ion concentration indicator (model number: F-72) manufactured by HORIBA, Ltd.

[Preparation of concentrate of polishing composition]

(Example 1)

A concentrate of a polishing composition, containing 33% by mass of colloidal silica (average primary particle size: 55 nm) as an abrasive, 200 mM of tetramethylammonium hydroxide (TMAH) as a basic compound, and 40 mM of 4-aminopiperidine as a nitrogen-containing organic compound was prepared by mixing the above components and ion-exchanged water at room temperature (25°C) and stirring the same for 30 minutes to achieve the respective concentrations. The pH of the concentrate of the polishing composition according to each example was 11.6.

Contents of respective components in the concentrate of the polishing composition are as follows:

colloidal silica 33% by mass
TMAH 200 mM
4-aminopiperidine 40 mM.

(Examples 2-10)

Concentrates of respective polishing compositions were prepared in the same manner as Example 1 except that the nitrogen-containing organic compounds shown in Table 1 below were respectively used instead of 4-aminopiperidine.

(Comparative Example 1)

A concentrate of a polishing composition was prepared in the same manner as Example 1 except that no nitrogen-containing organic compound was used.

(Comparative Examples 2-4)

Concentrates of respective polishing compositions were prepared in the same manner as Example 1 except that the nitrogen-containing organic compounds shown in Table 1 below were respectively used instead of 4-aminopiperidine.

(Evaluation on polishing removal rate)

Each of the prepared concentrates of polishing compositions was diluted by 30 times on volume basis using ion-exchanged water. A single side of a bear silicon wafer (60 mm x 60 mm, conductive type: p, crystal orientation: <100>) was polished in the following polishing conditions using each of these polishing compositions prepared after dilution to obtain a polished silicon wafer. The pH of the polishing composition after dilution was 10.4:

<Polishing conditions>

polishing device: desk polishing machine, EJ-380IN, manufactured by Engis Japan Corporation
pad: polyurethane pad, SUBA800, manufactured by NITTA DuPont Incorporated
polishing pressure: 16 kPa
flow rate of polishing composition: 100L/min
platen rotating speed: +50 rpm (anticlockwise rotation is taken as normal rotation when viewed from above polishing device)
head rotating speed: +45 rpm (anticlockwise rotation is taken as normal rotation when viewed from above polishing device)
maintained temperature of polishing composition: 25°C
machining allowance: 4 $\mu$m
polishing time: 14-18 minutes.

[Evaluation on polishing removal rate]

After polishing silicon wafers using the polishing compositions of the respective Examples and Comparative Examples, the polishing removal rate was calculated according to equations (1)-(3) below.
[Expression 1]

$$\Delta V = (W0 - W1)/d \quad (1)$$

$$\Delta x = \Delta V/S \quad (2)$$

$$R = \Delta x/t \quad (3)$$

$\Delta$V: Amount of change in volume of silicon wafer before and after polishing
W0: Weight of silicon wafer before polishing
W1: Weight of silicon wafer after polishing
d: Specific gravity of silicon (2.33)
S: Surface area of silicon wafer
$\Delta$x: Amount of change in thickness of silicon wafer before and after polishing
t: Polishing time

The polishing removal rate in Table 1 below indicates ratios with respect to the polishing removal rate as 100% obtained when the polishing composition of Comparative Example 1 is used, and the larger the numerical values are, the higher the polishing removal rate is.
Evaluation results are shown in Table 1 below.

[Table 1]

| | Nitrogen-containing organic compound | | HOMO level (eV) | Polishing removal rate |
| --- | --- | --- | --- | --- |
| | Compound name | Number of nitrogen atoms | | |
| Example 1 | 4-aminopiperidine | 2 | -9.17 | 113% |
| Example 2 | cis-1,2-cyclohexanediamine | 2 | -9.13 | 105% |
| Example 3 | 1,4-bis(3-aminopropyl) piperazine | 4 | -8.59 | 116% |
| Example 4 | N-(2-aminoethyl)piperazine | 3 | -8.90 | 115% |
| Example 5 | triethylenetetramine | 4 | -8.87 | 123% |
| Example 6 | ethylenediamine | 2 | -9.45 | 109% |
| Example 7 | diethylamine | 1 | -8.91 | 105% |
| Example 8 | 1-(3-aminopropyl)imidazole | 3 | -9.42 | 114% |
| Example 9 | 1,4-diazabicyclo[2,2,2]octane | 2 | -8.65 | 114% |
| Example 10 | piperazine | 2 | -8.96 | 111% |
| Comparative Example 1 | - | - | - | 100% |
| Comparative Example 2 | imidazole | 2 | -9.62 | 103% |
| Comparative Example 3 | urea | 1 | -10.31 | 103% |
| Comparative Example 4 | pyridine | 1 | -10.24 | 96% |

As clear from Table 1 above, it has been found that when the polishing compositions of Examples are used, silicon wafers can be polished at high polishing removal rate.

The present application is based on the Japanese patent application No. 2020-212274 filed on December 22, 2020, and the disclosed content thereof is incorporated in its entirety by reference.

**Claims**

1. A polishing composition used for polishing a silicon wafer, comprising:

   a nitrogen-containing organic compound having an energy level of a highest occupied molecular orbital (HOMO) of -9.50 eV or more, and
   water.

2. The polishing composition according to claim 1, wherein the nitrogen-containing organic compound is a compound having a saturated hydrocarbon cyclic group or a saturated heterocyclic group containing one nitrogen atom.

3. The polishing composition according to claim 1 or 2, further comprising an abrasive.

4. The polishing composition according to claim 3, wherein the abrasive is colloidal silica.

5. The polishing composition according to any one of claims 1 to 4, further comprising a basic compound other than the nitrogen-containing organic compound.

6. A method for polishing a silicon wafer, comprising performing polishing using the polishing composition according to any one of claims 1 to 5.

7. A concentrate of the polishing composition according to any one of claims 1 to 5.

## INTERNATIONAL SEARCH REPORT

| International application No. |
|---|
| **PCT/JP2021/044672** |

### A. CLASSIFICATION OF SUBJECT MATTER

*B24B 37/00*(2012.01)i; *H01L 21/304*(2006.01)i
FI:   H01L21/304 622A; B24B37/00 H

According to International Patent Classification (IPC) or to both national classification and IPC

### B. FIELDS SEARCHED

Minimum documentation searched (classification system followed by classification symbols)

B24B37/00; H01L21/304

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2008/093450 A1 (NITTA HAAS INCORPORATED) 07 August 2008 (2008-08-07) paragraphs [0005]-[0007], fig. 1-4 | 1, 3-7 |
| A | | 2 |
| X | JP 2014-505358 A (CABOT MICROELECTRONICS CORPORATION) 27 February 2014 (2014-02-27) paragraphs [0023]-[0111] | 1, 3-7 |
| A | | 2 |
| X | WO 2017/150158 A1 (FUJIMI INC) 08 September 2017 (2017-09-08) paragraph [0130] | 1, 3-7 |
| A | | 2 |
| X | JP 2018-049980 A (OKAMOTO MACHINE TOOL WORKS) 29 March 2018 (2018-03-29) paragraphs [0049], [0057]-[0058] | 1, 3-7 |
| A | | 2 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **18 January 2022** | **01 February 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2021/044672**

C.     DOCUMENTS CONSIDERED TO BE RELEVANT

| Category* | Citation of document, with indication, where appropriate, of the relevant passages | Relevant to claim No. |
|---|---|---|
| X | JP 2011-258825 A (NITTA HAAS INCORPORATED) 22 December 2011 (2011-12-22) paragraphs [0082]-[0157], fig. 3-4 | 1, 3-7 |
| A | | 2 |

### INTERNATIONAL SEARCH REPORT
**Information on patent family members**

International application No.

**PCT/JP2021/044672**

| Patent document cited in search report | | | Publication date (day/month/year) | Patent family member(s) | | | Publication date (day/month/year) |
|---|---|---|---|---|---|---|---|
| WO | 2008/093450 | A1 | 07 August 2008 | US paragraphs [0018]-[0086], fig. 1-4 | 2010/0025623 | A1 | |
| | | | | KR 10-2009-0128399 | | A | |
| | | | | CN | 101632157 | A | |
| | | | | TW | 200837180 | A | |
| JP | 2014-505358 | A | 27 February 2014 | US paragraphs [0024]-[0115] | 2011/0136344 | A1 | |
| | | | | WO | 2012/083115 | A2 | |
| | | | | CN | 103261358 | A | |
| | | | | KR 10-2014-0003475 | | A | |
| WO | 2017/150158 | A1 | 08 September 2017 | US paragraph [0153] | 2019/0061095 | A1 | |
| | | | | CN | 108713242 | A | |
| | | | | KR 10-2018-0122318 | | A | |
| | | | | TW | 201803963 | A | |
| JP | 2018-049980 | A | 29 March 2018 | (Family: none) | | | |
| JP | 2011-258825 | A | 22 December 2011 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015102101 A

- JP 2020212274 A